# EUROPÄISCHE PATENTSCHRIFT

(11) **EP 1 157 424 B1**
(45) Veröffentlichungstag und Bekanntmachung des Hinweises auf die Patenterteilung: **17.09.2008**
(21) Anmeldenummer: 00912346.4
(22) Anmeldetag: 03.02.2000
(51) Int. Cl.: H01L 29/10, H01L 29/74, H01L 29/32, H01L 31/111

(54) **VERFAHREN ZUM EINSTELLEN DER DURCHBRUCHSPANNUNG EINES THYRISTORS**
METHOD FOR REGULATING THE BREAKDOWN VOLTAGE OF A THYRISTOR
PROCEDE POUR REGLER LA TENSION DE CLAQUAGE D'UN THYRISTOR

(30) Priorität: 22.02.1999 DE 19907543
(43) Veröffentlichungstag der Anmeldung: 28.11.2001
(73) Patentinhaber: Infineon Technologies AG, 81669 München (DE)
(72) Erfinder: SCHULZE, Hans-Joachim, D-85521 Ottobrunn (DE); NIEDERNOSTHEIDE, Franz, Josef, D-81739 München (DE)
(74) Vertreter: Bickel, Michael
(86) Internationale Anmeldenummer: PCT/DE2000/000327
(87) Internationale Veröffentlichungsnummer: WO 2000/051187

(56) Entgegenhaltungen:
- EP-A- 0 297 325
- WO-A-92/17907
- WO-A-97/02603
- WO-A-98/15010
- WO-A-98/34282

## Beschreibung

Die Erfindung betrifft ein Verfahren zum Einstellen und zur Feinabstimmung der Durchbruchspannung an bereits gefertigten Thyristoren.

Ein Thyristor besitzt einen Halbleiterkörper, der aufeinanderfolgend einen n-dotierten katodenseitigen Emitter, eine p-dotierte katodenseitige Basis, eine n-dotierte anodenseitige Basis und einen p-dotierten anodenseitigen Emitter aufweist und dessen katodenseitiger Emitter mit einer als Katode dienenden Elektrode und dessen anodenseitiger Emitter mit einer als Anode dienenden Elektrode versehen ist. Wird eine elektrische Spannung mit dem Pluspol an die Anode und mit dem Minuspol an die Katode angelegt, befindet sich der Thyristor für niedrige Spannungsbeträge im Blockierbereich. Erhöht man die Spannung, wird bei Erreichen der (maximalen) Vorwärts-Sperrspannung, der sogenannten Durchbruchspannung (breakover voltage), auch als Kippspannung oder Nullkippspannung bezeichnet, ein Stromfluß in der Durchlaßrichtung eingeschaltet. Man sagt, der Thyristor zündet. Wird die Spannung zwischen Anode und Katode umgekehrt gepolt, befindet sich der Thyristor im Sperrbereich, der durch die Rückwärts-Sperrspannung begrenzt ist, bei der der Thyristor durchschlägt, so daß ein Strom in der Sperrichtung fließt.

Der Thyristor kann auch bei Anliegen einer Spannung im Blokkierbereich gezündet werden. Diese Zündung kann mit einem Steuerstrom bewirkt werden, der zwischen die katodenseitige Basis und den katodenseitigen Emitter angelegt wird, was beispielsweise über eine sogenannte Gate-Elektrode in einem dafür vorgesehenen Bereich des Halbleiterkörpers geschehen kann. Bei fehlendem Steuerstrom kann die Zündung auch als sogenannte Überkopfzündung durch Erhöhung der Spannung auf den Wert der Durchbruchspannung (Nullkippspannung) bewirkt werden, außerdem durch ausreichend steilen Anstieg der Spannung in Blockierrichtung oder durch Lichteinstrahlung in einen dafür eigens ausgebildeten Bereich des Halbleiterkörpers, vorwiegend der kathodenseitigen Basis.

Die Durchbruchspannung (Nullkippspannung) wird je nach dem Design des Thyristors durch unterschiedliche Effekte begrenzt. Zu einem Einschalten eines Stromflusses in der Durchlassrichtung kann es dadurch kommen, dass das elektrische Feld am sperrenden katodenseitigen pn-Übergang so groß wird, dass es zu einer Ladungsträgermultiplikation (Lawinendurchbruch, avalanche breakover) kommt, oder dadurch, dass die Raumladungszone sich nahezu über die gesamte Dicke der anodenseitigen Basis erstreckt und so weit an den anodenseitigen Emitter heranreicht, dass der Stromverstärkungsfaktor des anodenseitigen Transistors, der aus katodenseitiger Basis, anodenseitiger Basis und anodenseitigem Emitter gebildet wird, hinreichend groß wird, um den Thyristor einzuschalten (sogenannter Punch-through-Effekt). Welcher von den beiden Effekten zum Durchbruch führt, wird wesentlich durch die Dotierungsprofile der Basisbereiche bestimmt.

In der DE 196 50 762 A1 sowie in der darauf basierenden WO 98/15010 A ist ein Thyristor beschrieben, bei dem eine von der Raumladungszone überstrichene Zone in einem für eine Überkopfzündung vorgesehenen Bereich mit α-Teilchen oder Protonen bestrahlt ist, um das Profil der Ladungsträgerlebensdauer so zu modifizieren, dass die für das Überkopfzün- den erforderlichen Spannung begrenzt und in dem Bereich der Betriebstemperaturen weitgehend temperaturunabhängig wird. Die Überkopfzündung erfolgt bei diesem Thyristor in einer zentralen BOD-Struktur (breakover diode), die für eine Begrenzung der Durchbruchspannung vorgesehen ist.

Die WO 92/17907 A betrifft einen Thyristor mit einstellbarer Kippspannung. Um die Gefahr einer unkontrollierbaren Zündung des Thyristors zu beseitigen, ist eine durch maskierte Bestrahlung mit geladenen Teilchen erzeugte Zone vorgesehen, die sich im lateralen Bereich des Zündkontakts oder bei einem lichtzündbaren Thyristor im lateralen Bereich einer lichtempfindlichen Thyristorzone befindet und in der die Ladungsträgerlebensdauer reduziert ist. In der vertikalen Richtung ist diese Zone mit reduzierter Ladungsträgerlebensdauer in der anodenseitigen Hälfte der n-dotierten Basis angeordnet.

Aus der EP 0 297 325 A ist ein Gate-Turn-Off-Thyristor bekannt, bei dem in der n-dotierten Basis nahe des pn-Übergangs zwischen der n-dotierten Basis und der p-dotierten Basis eine durch Bestrahlung erzeugte Schädigungszone vorgesehen ist, die sich über die gesamte Breite des Thyristors erstreckt und die dazu dient, in der Abschaltzeit des Thyristors die Speicherzeit und die Gateumkehrladung zu reduzieren.

In der US 4,987,087 ist ein Herstellungsverfahren für Thyristoren beschrieben, bei dem der ansonsten fertiggestellte Thyristor mit Protonen bestrahlt wird, deren Eindringtiefe auf die katodenseitige Hälfte der anodenseitigen Basis eingestellt wird. Auf diese Weise werden dort Störstellen erzeugte die als Donatoren wirken und die Ladungsträgerkonzentration lokal erhöhen, um die Durchbruchspannung abzusenken. Dadurch wird zwar die Lawinendurchbruchspannung erniedrigt, andererseits jedoch der Stromverstärkungsfaktor des anodenseitigen Transistors durch die Verringerung der Ausdehnung der Raumladungszone erniedr,igt, so daß eine kontrollierte Absenkung der Durchbruchspannung sehr schwierig ist.

Aufgabe der vorliegenden Erfindung ist es, ein Verfahren anzugeben, mit dem die Durchbruchspannung (Nullkippspannung) fertiggestellter Thyristoren eingestellt werden kann.

Diese Aufgabe wird mit dem Verfahren mit den Merkmalen des Anspruches 1 gelöst. Ausgestaltungen ergeben sich aus den abhängigen Ansprüchen.

Bei dem erfindungsgemäßen Verfahren wird das effektive Dotierungsprofil des fertiggestellten Thyristors durch Bestrahlung mit einer geeigneten Ionenart in einem für eine Zündung vorgesehenen Bereich, z. B. einer BOD-Struktur, so verändert, daß die Durchbruchspannung zumindest innerhalb unvermeidlicher Toleranzen auf einen vorgegebenen Wert eingestellt wird. Die Ionenart wird so gewählt, daß durch das Einstrahlen in dem Halbleitermaterial Störstellen erzeugt werden, die den Dotierstoffatomen entgegenwirken. Am wirkungsvollsten sind dabei Veränderungen in der schwächer dotierten Zone, in der Regel der anodenseitigen Basis und dort vorzugsweise in der Nähe des pn-überganges zwischen der anodenseitigen und der katodenseitigen Basis. Für die Modifizierung der n-dotierten Basis sind insbesondere Heliumionen geeignet, die in einem Bereich, in dem die Heliumionen stark abgebremst werden, akzeptorartige Zustände erzeugen, die die effektive n-Dotierung erniedrigen. Der Bereich, in dem die Heliumionen stark abgebremst werden, befindet sich in der Regel dicht vor der zumindest näherungsweise bestimmbaren maximalen Eindringtiefe.

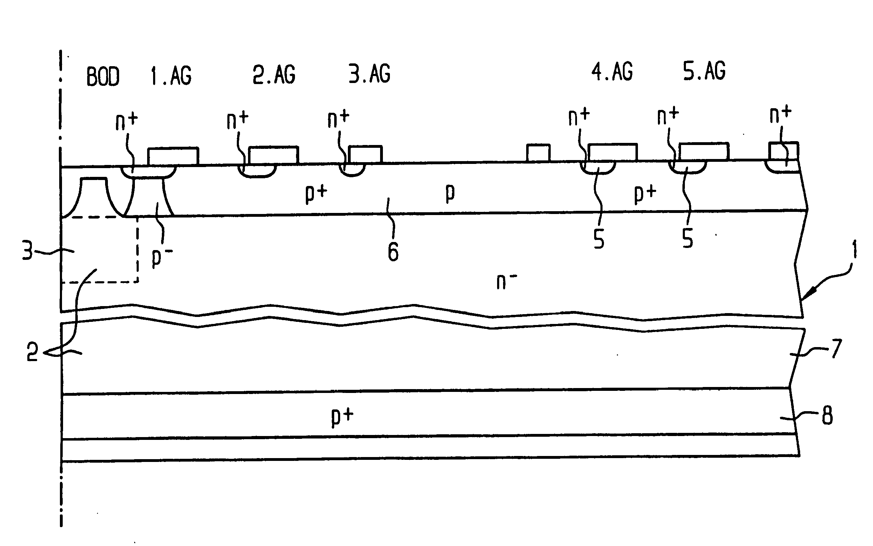

Zur Erläuterung des Verfahrens anhand eines Beispiels ist in der beigefügten Figur ein Thyristor im Querschnitt dargestellt. Zur Vergrößerung des Maßstabes ist in der Figur nur eine Hälfte des Querschnittes dargestellt, der zur Vervollständigung an der auf der linken Seite eingezeichneten senkrechten strichpunktierten Linie gespiegelt zu denken ist.

Der Thyristor besitzt einen Halbleiterkörper 1, der aufeinanderfolgend einen n-dotierten katodenseitigen Emitter 5, eine p-dotierte katodenseitige Basis 6, eine n-dotierte anodenseitige Basis 7 und einen p-dotierten anodenseitigen Emitter 8 aufweist. In dem Halbleiterkörper 1 ist ein Bereich 2 vorhanden, in dem ein Stromfluß gezündet wird, wenn eine in Durchlaßrichtung gepolte elektrische Spannung zwischen anodenseitigem und katodenseitigem Emitter den Wert der Durchbruchspannung dieses Bereiches erreicht. Diese Spannung wird an die eingezeichneten Kontakte auf der Ober- und Unterseite des Halbleiterkörpers angelegt. Es ist eine Reihe von sogenannten AG-Strukturen (amplifying gate) eingezeichnet, die bei einer Zündung des Thyristors in der Reihenfolge der eingezeichneten Numerierung zünden. Der Thyristor ist vorzugsweise rotationssymmetrisch, so daß der in der Figur gezeigte Querschnitt von links nach rechts die Thyristorstruktur vom Zentrum nach außen hin darstellt.

Der zentrale Bereich 2 des Thyristors ist in diesem Beispiel für eine Zündung mittels eingestrahlten Lichtes ausgebildet. Um sicherzustellen, daß der Thyristor bei Überspannungen in Blockierrichtung zuerst im Zentrum zündet und die eigentliche Zündung des Stromflusses in Durchlaßrichtung nacheinander über die AG-Strukturen erfolgt, kann in dem für die Zündung vorgesehenen Bereich 2 eine BOD-Struktur vorhanden sein, wie sie z. B. in der eingangs zitierten DE 196 50 762 A1 beschrieben ist. Die maximale Spannung, die vor Zündung des Thyristors erreichbar ist, wird hier durch die Lawinendurchbruchspannung der Schutzdiode im Zentrum bestimmt. Die Lawinendurchbruchspannung hängt maßgeblich von den Krümmungseigenschaften der Begrenzung des zentralen Anteils des die katodenseitige Basis bildenden p-dotierten Bereichs ab.

Von Bedeutung für eine nachträgliche Modifikation der Durchbruchspannung ist insbesondere, daß eine lokale Erniedrigung der n-Dotierung in der katodenseitigen Hälfte der anodenseitigen Basis, z. B. in der Umgebung des sperrenden pn-Übergangs, dort eine entsprechende Erniedrigung der elektrischen Feldstärke bewirkt. Das führt zum einen zu einer Erhöhung der Lawinendurchbruchspannung der Schutzdiode und zum anderen dazu, daß die Raumladungszone, die sich an dem sperrenden pn-Übergang ausbildet, bei gleicher Anoden-Katoden-Spannung tiefer in die anodenseitige Basis hineinreicht. Das bewirkt dann eine Vergrößerung des Stromverstärkungsfaktors des pnp-Transistors, der aus der katodenseitigen Basis, der anodenseitigen Basis und dem anodenseitigen Emitter gebildet wird, und damit des Sperrstromes.

Wird durch die nachträgliche Bestrahlung die effektive Dotierung nur in einer kleinen katodenseitigen Zone 3 der anodenseitigen Basis 7 und nicht zu stark verringert, so wirkt sich das bei hinreichend großer Länge der anodenseitigen Basis (hinreichend große Dicke der die anodenseitigen Basis bildenden n-dotierten Halbleiterschicht) nur schwach auf den Stromverstärkungsfaktor des pnp-Transistors aus. Die Absenkung der maximalen Feldstärke am sperrenden pn-Übergang führt also auf Grund der Erhöhung der Lawinendurchbruchspannung der Schutzdiode zu einer entsprechenden Erhöhung der Durchbruchspannung des Thyristors. Dagegen bewirkt eine starke Erniedrigung der effektiven n-Dotierung in der anodenseitigen Basis innerhalb eines größeren Bereiches eine Erniedrigung der Durchbruchspannung, da dann der Einfluß auf den Stromverstärkungsfaktor dominiert. Die Raumladungszone nähert sich in diesem Fall dem anodenseitigen Emitter 8 lange, bevor die Lawinendurchbruchspannung des sperrenden pn-Überganges in dem für die Zündung vorgesehenen Bereich 2 erreicht wird.

Die für die gewünschte Anwendung erforderliche lokale Erniedrigung der effektiven Dotierungskonzentration in der anodenseitigen Basis läßt sich durch eine vorzugsweise katodenseitige Bestrahlung des Thyristors in dem zentralen, zur Zündung vorgesehenen Bereich 2 beispielsweise mit Heliumionen erzielen. Die Energie der Bestrahlung wird entsprechend der erforderlichen Eindringtiefe ausreichend hoch eingestellt. Durch diese Bestrahlung werden akzeptorartige Zustände erzeugt, die die effektive n-Dotierung verringern. Eine analoge Verringerung einer p-Dotierung läßt sich beispielsweise mittels Bestrahlung mit Protonen erzielen, wie das anhand einer andersartigen Anwendung in der eingangs zitierten US 4,987,087 beschrieben ist. Die Bestrahlung mit Teilchen führt außerdem zur Erzeugung von Defekten im Halbleitermaterial, vorzugsweise Silizium, die eine Erniedrigung der Generationslebensdauer und damit einen lokalen Anstieg des Leckstromes infolge der erhöhten Dichte freier Ladungsträger bewirken. Dadurch kommt es als Ergebnis zu einer weiteren Reduktion der Durchbruchspannung. Von Vorteil ist dabei, daß der Einfluß auf den Gesamtleckstrom klein ist, wenn nur kleine Volumina in dem Halbleitermaterial bestrahlt werden. Es können sowohl Erhöhungen wie Erniedrigungen der Durchbruchspannung mit dem erfindungsgemäßen Verfahren auf einfache und vergleichsweise genaue Weise bewerkstelligt werden.

Wie weit die Durchbruchspannung abgesenkt oder angehoben wird, kann über die Dosis und die Energie der Bestrahlung eingestellt werden. Eine mehrmalige Bestrahlung mit unterschiedlichen Energien erlaubt, die effektive Dotierung der anodenseitige Basis in Bereichen mit Abmessungen von mehreren hundert Mikrometern gezielt zu modifizieren. Die erzeugten Defekte oder Störstellen werden vorzugsweise durch eine Temperung bei Temperaturen um 250°C ausgeheilt, um elektrische Instabilitäten zu verhindern. Ein solcher Prozeßschritt kann unbedenklich mit einem ansonsten fertiggestellten Thyristor vorgenommen werden.

## Patentansprüche

1. Verfahren zum Einstellen einer Durchbruchspannung eines Thyristors,
- der einen Halbleiterkörper (1) besitzt, der aufeinanderfolgend einen n-dotierten katodenseitigen Emitter (5), eine p-dotierte katodenseitige Basis (6), eine n-dotierte anodenseitige Basis (7) und einen p-dotierten anodenseitigen Emitter (8) aufweist, und
- bei dem in dem Halbleiterkörper (1) ein zentraler Bereich (2) vorhanden ist, in dem ein Stromfluss gezündet wird, wenn eine in Durchlassrichtung gepolte elektrische Spannung zwischen anodenseitigem und katodenseitigem Emitter den Wert der Durchbruchspannung erreicht,
wobei lokal in den für die Zündung vorgesehenen zentralen Bereich (2) Ionen eingestrahlt werden, die in einer katodenseitigen Hälfte der anodenseitigen Basis (7) Störstellen erzeugen, die als Akzeptoren wirken.

2. Verfahren nach Anspruch 1,
bei dem die Ionen so eingestrahlt werden, dass die Störstellen in einer an die katodenseitige Basis (6) angrenzenden Zone (3) der anodenseitigen Basis (7) erzeugt werden.

3. Verfahren nach Anspruch 1 oder 2,
bei dem Heliumionen eingestrahlt werden.

## Claims

1. Method for setting a breakdown voltage of a thyristor,
- which has a semiconductor body (1) having, in succession, an n-doped cathodal emitter (5), a p-doped cathodal base (6), an n-doped anodal base (7) and a p-doped anodal emitter (8), and
- in which the semiconductor body (1) contains a central region (2) in which a current flow is triggered if a reverse-biased electrical voltage between anodal and cathodal emitter reaches the value of the breakdown voltage,
wherein ions are radiated locally into the central region (2) provided for triggering and produce defects in a cathodal half of the anodal base (7), which defects act as acceptors.

2. Method according to Claim 1,
in which the ions are radiated in such a way that the defects are produced in a zone (3) of the anodal base (7) which adjoins the cathodal base (6) .

3. Method according to Claim 1 or 2, in which helium ions are radiated in.

## Revendications

1. Procédé de réglage d'une tension de claquage d'un thyristor
- qui a un corps à semi-conducteurs, qui comporte successivement un émetteur ( 5 ) à dopage n du côté cathode, une base ( 6 ) à dopage p du côté cathode, une base ( 7 ) à dopage n du côté anode et un émetteur ( 8 ) à dopage p du côté anode, et
- dans lequel il y a dans le corps à semi-conducteurs une zone ( 2 ) centrale dans laquelle est amorcée un flux de courant lorsqu'une tension électrique entre l'émetteur côté anode et l'émetteur côté cathode polarisée dans le sens passant atteint la valeur de la tension de claquage,
- dans lequel on injecte, dans la zone ( 2 ) centrale et prévue pour l'amorçage, des ions qui produisent dans une moitié côté cathode de la base ( 7 ) côté anode des imperfections qui agissent en tant qu'accepteurs.

2. Procédé suivant la revendication 1,
- dans lequel on injecte les ions de façon à produire les imperfections dans une région ( 3 ) de la base ( 7 ) côté anode, qui avoisine la base ( 6 ) côté cathode.

3. Procédé suivant la revendication 1 ou 2,
- dans lequel on injecte des ions hélium.
